# FASCICULE DE BREVET EUROPEEN

(11) **EP 0 851 588 B1**
(45) Date de publication et mention de la délivrance du brevet: **14.04.2004**
(21) Numéro de dépôt: 97204002.6
(22) Date de dépôt: 18.12.1997
(51) Int. Cl.: H03L 7/089, H03K 17/66

(54) **Circuit de pompe de charge, destiné à être utilisée dans une boucle de réglage de fréquence d'un synthétiseur de fréquence**
Ladungspumpenschaltung für die Frequenzregelschleife eines Frequenzsynthetisierers
Charge pump circuit for the frequency control loop of a frequency synthesizer

(30) Priorité: 31.12.1996 FR 9616264
(43) Date de publication de la demande: 01.07.1998
(73) Titulaire: Koninklijke Philips Electronics N.V., 5621 BA Eindhoven (NL)
(72) Inventeur: Ridgers, Timothy, 75008 Paris (FR)
(74) Mandataire: Charpail, François

(56) Documents cités:
- EP-A- 0 606 772
- US-A- 4 322 643
- US-A- 4 814 726
- US-A- 5 184 028
- US-A- 5 465 061
- "HIGH-SPEED BICMOS CHARGE PUMP" IBM TECHNICAL DISCLOSURE BULLETIN., vol. 34, no. 4A, 1 septembre 1991, NEW YORK US, pages 360-362, XP000210925

## Description

La présente invention concerne un circuit de pompe de charge, destiné à être utilisée dans une boucle de réglage de fréquence d'un synthétiseur de fréquence muni d'un oscillateur local et d'un oscillateur de référence, circuit comprenant une capacité réservoir, une source de courant de charge de sortie commandée et une source de courant de décharge de sortie commandée.

Elle concerne aussi un circuit intégré comprenant un circuit de pompe de charge.

Elle concerne enfin un récepteur d'ondes hertziennes comprenant un synthétiseur avec une pompe de charge, par exemple un récepteur de radio ou de télévision, ou également un radiotéléphone (tous types : GSM, DECT, CT2, etc).

Un circuit de pompe de charge selon le paragraphe introductif ci-dessus est connue du document US 5,184,028 (Don W. Zobel).

Un circuit de pompe de charge est également connu du document US 4,322,643.

Un circuit de pompe de charge est également connu du document EP 0,606,772 qui décrit un circuit de pompe de charge destiné à être utilisé en combinaison avec un filtre de boude et avec un oscillateur contrôlé en tension générant un signal de sortie. Le circuit de pompe de charge comprend un premier circuit pour délivrer un courant au filtre de boude, et un deuxième circuit comprenant des éléments identiques au premier circuit pour recevoir un courant du filtre de boude.

La boucle de réglage de fréquence d'un synthétiseur de fréquence contient une pompe de charge, qui sert, de façon connue, à charger ou à décharger une capacité, chaque fois qu'il y a détection d'une erreur de phase dans un sens ou dans l'autre entre le signal de l'oscillateur local et le signal de l'oscillateur de référence. La pompe de charge intervient donc pour compenser des dérives de phase. Son fonctionnement est critique du point de vue bruit, puisque le signal d'erreur est utilisé comme référence de fréquence pour le traitement du signal utile.

Idéalement, les sources de courant de la pompe de charge émettent des pulsations de courant de très faible durée, de l'ordre de quelques nanosecondes par exemple, d'une amplitude contrôlée, et d'une grande pureté spectrale. Si le résultat de la sommation des deux pulsations, d'amplitude égale mais de polarité opposée, est zéro, tel n'en est pas pour autant le cas de leur sommation en bruit. Certaines contributions en bruit sont corrélées entre les deux sources, leur somme est nulle. D'autres parties sont dues à des mécanismes de bruit indépendants, dont les puissances de bruit s'ajoutent. Ce résidu limite la qualité du signal sortant de l'oscillateur.

L'invention a entre autres pour but de procurer un circuit de pompe de charge dont la contribution en bruit soit minimisée, et comprenant un circuit de commande commandant de façon accélérée des sources de charge et de décharge, à partir de signaux de mise en route.

A cet effet, une des sources de courant de sortie possède une entrée de commande reliée à la sortie d'un premier circuit de commande relié à la sortie d'une première bascule dont une entrée est reliée au signal de l'oscillateur local et dont la sortie est reliée au premier circuit de commande pour lui fournir un signal de mise en route, l'autre source de courant de sortie possède une entrée de commande reliée à la sortie d'un second circuit de commande relié à la sortie d'une seconde bascule dont une entrée est reliée au signal de l'oscillateur de référence et dont la sortie est reliée au second circuit de commande pour lui fournir un signal de mise en route, les deux circuits de commande sont de construction identique, chacune des sources de courant comporte une source basique, de construction identique pour les deux sources de courant, et telle que le courant qu'elle produit soit fixé par le signal issu du circuit de commande correspondant, et il comporte un circuit régulateur pour fournir, en commun pour les deux circuits de commande, des tensions de polarisation ainsi qu'une référence de courant.

L'invention est donc basée sur l'idée d'utiliser des éléments dont les sources de bruit soient corrélées, de manière qu'elles s'annulent. Grâce à l'identité de construction entre les éléments du circuit régulateur et ceux analogues des circuits de commande, la qualité du signal de commande est augmentée.

Avantageusement, le circuit de pompe comporte en outre une porte logique dont deux entrées sont reliées respectivement à une sortie de signal dit de fin de mise en route du premier circuit de commande et à une sortie de signal dit de fin de mise en route du second circuit de commande, et dont la sortie est reliée à une entrée de remise dans un état inactif de chacune des deux bascules et de chacun des deux circuits de commande.

Ainsi, le bruit généré par la porte est transmis simultanément aux deux voies et s'annule.

Le circuit de commande selon l'invention comprend une source de courant faite d'un transistor dit transistor source, en série avec une résistance, transistor source qui est commandé par une paire dite paire différentielle, faite de transistors de polarité opposée à celle du transistor source, dont les bases sont attaquées par un signal symétrique issu de la bascule à laquelle le circuit de commande est relié, un des transistors de la paire commandant la base du transistor source et l'autre commandant l'émetteur du transistor source.

Ainsi la commutation du transistor source est plus rapide.

Un circuit de commande comprend avantageusement une source de courant dont le courant est introduit dans un montage miroir de courant comportant un circuit du type multiplicateur de V_{be}.

Ainsi le bruit venant de l'amont est atténué par le miroir.

Le miroir comprend avantageusement un transistor générateur de courant qui débite dans une paire de deux transistors agissant en mode dit cascode, dont les bases sont reliées respectivement aux deux composantes du signal de sortie de la porte logique, ce signal étant symétrique.

L'aiguillage du courant du miroir par commutation en mode cascode permet d'arrêter plus rapidement les courants de charge et de décharge.

Le collecteur d'un premier des transistors en mode cascode est avantageusement relié à une alimentation par une résistance dite de charge, le collecteur du second de ces transistors est relié à l'alimentation par un montage en parallèle d'un transistor monté en diode et de deux résistances en série, le point commun entre la résistance de charge et le collecteur qui lui est relié constitue la sortie du circuit de commande, sortie reliée à une entrée de commande d'une des sources de courant de sortie, et le point commun aux deux résistances en série est connecté au collecteur d'un transistor dont l'émetteur est connecté à la sortie du circuit de commande et dont la base est polarisée par une tension de référence, le dit point commun constituant la sortie de signal dit de fin de mise en route.

De préférence, le circuit de pompe est munie de moyens pour activer ou désactiver les circuits de commande.

Ainsi, le courant consommé en permanence par le synthétiseur est moins élevé.

Chacune des bascules qui fournissent un signal de mise en route comporte avantageusement deux transistors suiveurs pour délivrer les deux composantes du signal de commande, et ces deux transistors suiveurs sont chacun l'un des transistors d'une paire différentielle dont l'autre transistor est relié à une entrée de signal de test.

Un tel montage procure à faible coût un moyen de test puissant.

Dans un circuit intégré comprenant un circuit de pompe de charge, ainsi que dans un récepteur d'ondes hertziennes comprenant un synthétiseur avec un circuit de pompe de charge, ce circuit est avantageusement un circuit de pompe de charge selon l'invention.

Ces aspects de l'invention ainsi que d'autres aspects plus détaillés apparaîtront plus clairement grâce à la description suivante d'un mode de réalisation.
La figure 1 représente schématiquement un récepteur d'ondes hertziennes, ici par exemple un récepteur de télévision.
La figure 2 représente schématiquement un circuit de pompe de charge selon l'invention.
La figure 3 est un schéma détaillé du module 20 de la figure 2.
La figure 4 est un schéma détaillé du module 60 de la figure 2.
La figure 5 est un schéma détaillé du module 30A de la figure 2.
La figure 6 est un schéma détaillé du module 40B de la figure 2.

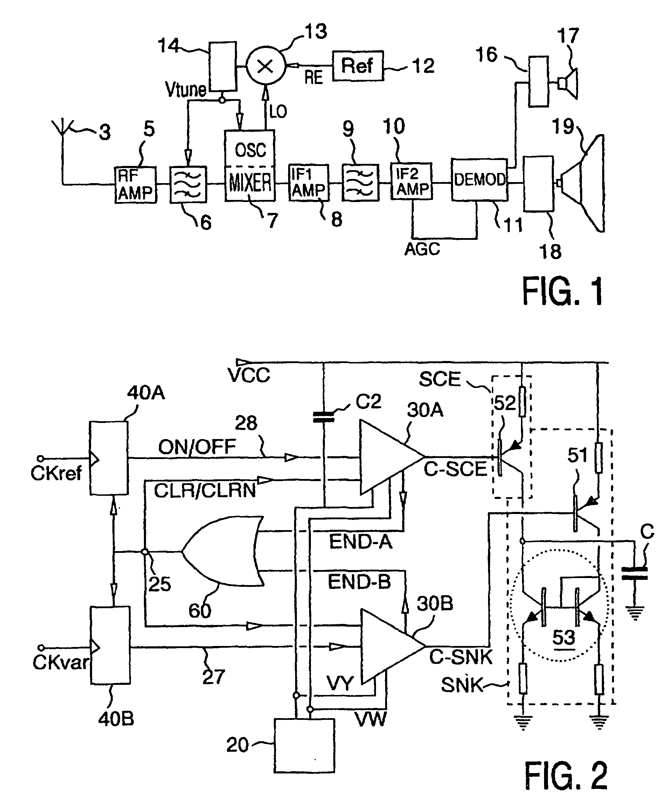

Le récepteur d'ondes hertziennes représenté à titre d'exemple par la figure 1 est ici un récepteur de télévision, mais l'invention s'appliquerait aussi bien à tout autre appareil muni d'un circuit de pompe de charge, entre autres à un radiotéléphone.

Il comprend à partir d'une antenne 3, un amplificateur radio-fréquences 5, éventuellement un filtre passe-bande à fréquence réglable 6, un mélangeur ou changeur de fréquence 7, comprenant un oscillateur local, un premier amplificateur à fréquence intermédiaire 8, un filtre passe-bande 9 à fréquence fixe du type dit à ondes de surface, un deuxième amplificateur à fréquence intermédiaire 10, un démodulateur 11, qui fournit en sortie des signaux démodulés à un circuit de traitement vidéo 18 alimentant par exemple un tube cathodique 19, et à un circuit 16 de traitement audio, alimentant par exemple un haut-parleur 17.

L'oscillateur local est piloté par un synthétiseur de fréquence dit "PLL", qui comporte, de façon connue, une boucle de contrôle de phase avec un comparateur de phase 13 qui compare la fréquence du signal LO de l'oscillateur local par rapport à celle du signal RE d'un oscillateur de référence 12 à quartz, et délivre, via un filtre passe-bas 14, une tension de commande "Vtune" qui sert à régler la fréquence de l'oscillateur local, et aussi à régler le filtre 6.

Plusieurs éléments de cet ensemble peuvent être réalisés ensemble sous la forme d'un circuit intégré, comprenant notamment l'élément qui délivre la tension de commande de l'oscillateur local, muni des perfectionnements qui vont être décrits maintenant.

L'élément 13 contient un circuit de pompe de charge, qui sert à charger ou à décharger une capacité, chaque fois qu'il y a erreur de phase entre les signaux LO et RE.

La figure 2 montre la structure d'ensemble de cette pompe de charge, branchée entre une alimentation VCC et la masse. Elle comporte un étage de sortie fait d'une source de courant de charge de sortie SCE, et d'une source de courant de décharge de sortie SNK. Cet étage de sortie est réalisé, pour SCE, à l'aide d'une source de courant basique réalisée à partir d'un transistor 52 dont l'émetteur est relié via une résistance à l'alimentation VCC et dont la base est commandée par le signal C-SCE sortant du circuit de commande 30A, et pour SNK à l'aide d'une source basique de construction identique, réalisée à partir d'un transistor 51 commandé par le signal sortant du circuit de commande 30B, et dont le courant est "retourné" par un miroir de courant 53 du côté masse. En pratique, chacune des sources est en réalité constitué par "n", par exemple seize, sources basiques unitaires en parallèle. La valeur du courant produit est fonction de la valeur de la tension de commande C-SCE ou respectivement C-SNK, par rapport à l'alimentation VCC. Les courants de ces deux sources SCE et SNK se retranchent l'un de l'autre à la sortie, dans une capacité C dont la tension de charge représente la susdite tension de commande.

Le signal de l'oscillateur de référence est amené à l'entrée d'horloge Ckref d'une bascule 40A de type D, et le signal de l'oscillateur local est amené à l'entrée d'horloge Ckvar d'une autre bascule 40B de même type. Ces bascules sont du genre D mais toutefois pas rigoureusement des bascules D : elles basculent sur une impulsion d'horloge CK/CKN, mais elles sont rétablies dans leur état initial par la commande asynchrone CLR/CLRN. La pulsation du courant de sortie est initiée par les bascules 40A, 40B. Compte tenu de la forte capacité présentée par les bases des transistors des sources de courant de l'étage de sortie, une interface ayant une sortance appropriée, appelée circuit de commande, est insérée à chaque fois entre les bascules et l'étage de sortie. Ainsi le signal de sortie 28 de la bascule 40A est amené à une entrée d'un circuit de commande 30A dont la sortie C-SCE commande la source de courant de charge de sortie SCE, et le signal de sortie 27 de la bascule 40B est amené à une entrée d'un circuit de commande 30B dont la sortie C-SNK commande la source de courant de décharge de sortie SNK. Quand il n'y a pas d'erreur de phase, les deux sources s'annulent. La charge transférée par cycle de comparaison est proportionnelle à l'erreur de phase.

Une porte logique 60 de type OU possède deux entrées auxquelles est amené respectivement un signal de détection de fin de mise en conduction de la source SCE, délivré par le circuit de commande 30A, et un signal de détection de fin de mise en conduction de la source SNK, délivré par le circuit de commande 30B. Sa sortie est reliée en même temps aux bascules 40 et aux circuits de commande 30. Chacune des deux bascules 40A ou 40B fournit un signal de mise en route au circuit de commande associé, et se trouve remis dans un état inactif par un signal 25 sortant de la porte logique 60, lorsque les deux courants de sortie des sources SCE et SNK sont simultanément présents. Le signal 25 commute simultanément deux transistors montés en cascode, dans chaque circuit de commande 30. Le bruit introduit par la porte 60 est transmis simultanément sur les deux voies de façon correlée, s'annulant ainsi en sortie de la pompe de charge.

Pour simplifier, les conducteurs 25, 27, 28 sont indiqués par des connexions simples ; en pratique il s'agit à chaque fois de signaux symétriques portés par deux conducteurs, qui seront désignés, lors de la description ultérieure du circuit de commande 30A, par CLR et CLRN, en ce qui concerne le conducteur 25, et par ON et OFF, en ce qui concerne le conducteur 28.

Des tensions de polarisation VW, VY communes aux circuits de commande 30 viennent d'un circuit 20 appelé régulateur, qui fixe le courant unité de sortie de la pompe de charge, indépendamment des variations de température et d'alimentation. La tension VY est découplée par une capacité C2 reliée à l'alimentation VCC.

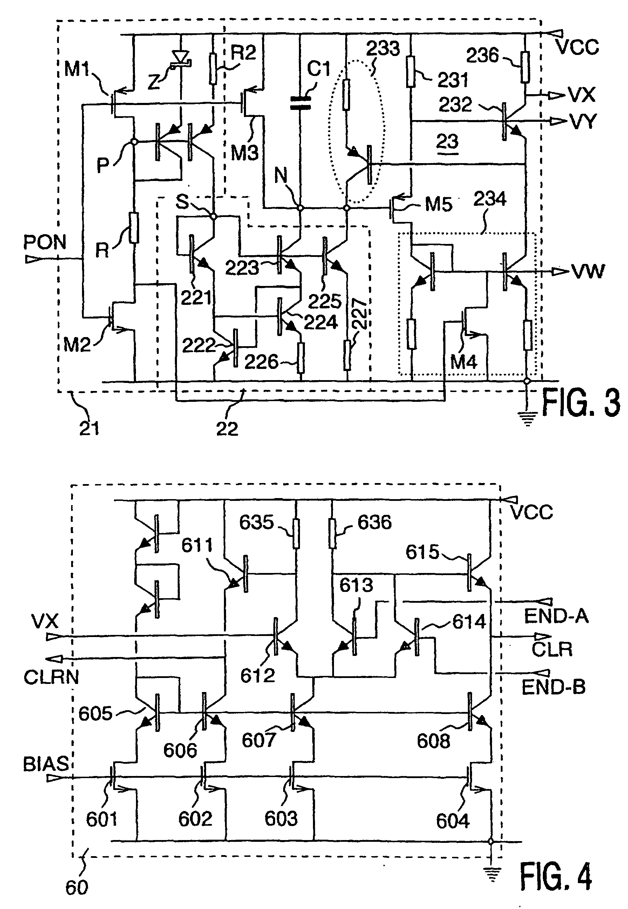

Le régulateur 20 représenté à la figure 3 réalise la référence de courant unitaire à la sortie de la pompe de charge, ainsi que les tensions de polarisation des circuits de commande. Il comporte trois parties 21, 22, 23. Une partie 21 est prévue pour démarrer ou arrêter la cellule. Elle reçoit un signal PON de commande de marche/arrêt, qui ouvre l'un ou l'autre des transistors MOS M1 ou M2. Lorsque PON est à l'état haut, le transistor M2 est conducteur, et le courant dans la résistance R est recopié par un miroir de courant pré-réglé, c'est-à-dire avec une diode Schottky Z dans la connexion d'émetteur de son transistor pilote, et une résistance R2 dans la connexion d'émetteur de son transistor source de courant. Ce miroir, connecté au point P, fournit un courant au transistor 221, monté en diode, dans la partie 22. Le montage 22 est connu en soi il est basé sur le fait que les transistors 221 et 224 sont par exemple faits chacun de quatre transistors basiques en parallèle, et sont donc beaucoup plus larges que les transistors simples 222 et 223. Partant du point S, les V_{be} des deux transistors 222 et 223 en série, d'une part, et les espaces base-émetteur des transistors 221 et 224, d'autre part, engendrent des tensions inégales du fait que les deux transistors 221 et 224 sont plus larges, et la différence se retrouve aux bornes de la résistance 226. Cette tension détermine le courant dans la résistance 226 et les transistors 224 et 223, et une autre branche faite du transistor 225 en série avec la résistance 227 fournit elle aussi du courant qui s'ajoute au précédent dans le noeud N. La somme des courants ainsi fabriquée, à condition de bien choisir la pondération entre le courant dans le transistor 223 et celui dans le transistor 225, fournit un courant indépendant de la température et de la tension d'alimentation.

Ce courant de référence unitaire vient sur le miroir de courant composé 23. Ce dernier contient un premier étage suiveur fait d'un transistor M5 de type P-MOS chargé par une résistance 231, sur laquelle est prélevée la tension VY, puis un deuxième étage suiveur 232 de type NPN, possédant en outre une résistance de collecteur 236, sur laquelle est prélevée une tension VX destinée à la porte 60, et enfin une source de courant rebouclée 233. Le courant de collecteur du premier étage suiveur M5 est récupéré dans un miroir de courant 234 pour fournir la polarisation en courant de l'étage suiveur NPN 232, et la référence de tension VW. Ceci permet de réduire le nombre de circuits nécessaires.

Pour ne pas pénaliser le courant consommé en permanence par le synthétiseur, les circuits de commande ne sont activés que pendant une partie du temps, par exemple dans le cas d'un radiotéléphone en veille, lors des périodes de scrutation. Lorsque le signal PON est bas, un transistor M4 court-circuite le miroir 234, et un transistor M3 prélève le courant du noeud N. Une capacité C1, d'environ 2 Pf, entre l'alimentation VCC et le noeud N, garantit la stabilité du montage.

La source 233 est appairée, c'est-à-dire de construction identique, à celles à partir desquelles est réalisé l'étage de sortie. De même l'étage suiveur 232 est appairé avec deux transistors-limiteurs du circuit de commande, qui seront décrits ci-après. Du fait de ces appairages, les courants produits par les sources SCE et SNK sont le reflet, à un facteur d'échelle près, du courant de référence unitaire produit par le régulateur de la figure 3.

Le module 60 représenté sur la figure 4 est muni d'une pluralité de transistors MOS 601-604, polarisés par une tension BIAS. Lorsque la tension d'alimentation est inférieure à environ 3,5 volts, ces transistors servent de résistances de définition de courant pour des transistors 606-608 miroirs constituant, avec un transistor pilote 605, des sources de courant, qui fonctionnent alors en mode cascode. Le module comprend essentiellement un montage analogue à une paire différentielle, mais comprenant deux transistors de l'un des côtés : le transistor source de courant 607 débite dans la paire constituée du transistor 612 d'un côté, et des transistors 613, 614 de l'autre côté. La base du transistor 612 est alimentée par la tension de référence VX fournie par le régulateur 20. Les bases des transistors 613 et 614 sont alimentées par les tensions symétriques respectivement END-A et END-B en provenance du régulateur 20, qui indiquent la fin de la mise en conduction d'une source SCE ou SNK. Les collecteurs des transistors, 613, 614 sont reliés ensemble à l'alimentation VCC par une résistance 636, et le collecteur du transistor 612 est relié à l'alimentation VCC par une résistance 635. La tension sur la résistance 636 est appliquée à la base du transistor 615 monté en émetteur suiveur chargé par la source de courant 608, et fournissant le signal CLR. La tension sur la résistance 635 est appliquée à la base du transistor 611 monté en émetteur suiveur chargé par la source de courant 606, et fournissant le signal CLRN.

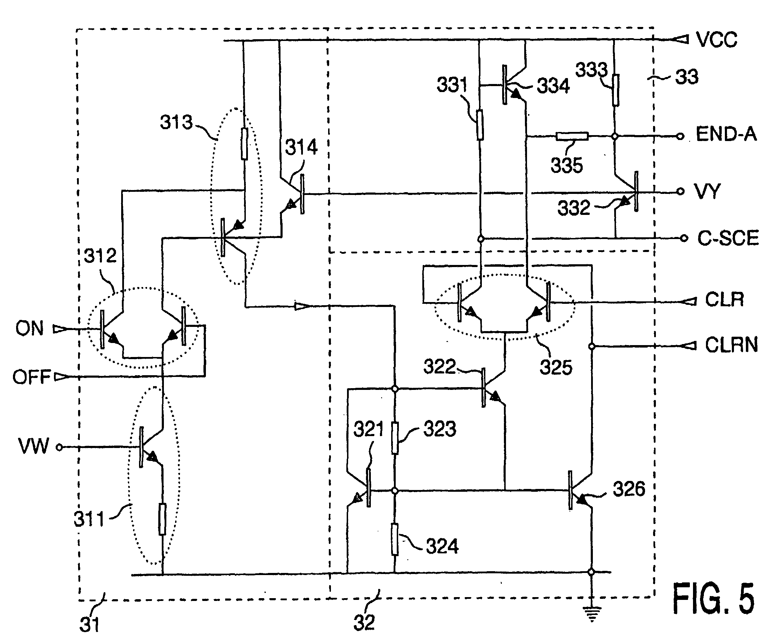

Le circuit de commande 30A est représenté par la figure 5. Le circuit de commande 30B est identique, en remplaçant "A" par "B" et "SCE" par "SNK". Il comporte trois parties 31, 32, 33.

La partie 31 assure la mise en route, elle comporte une source de courant 313, comprenant un transistor PNP dit transistor source monté en émetteur suiveur avec une résistance de charge depuis l'alimentation VCC, transistor qui est brutalement commandé à la fois sur l'émetteur et sur la base par les courants sortant d'une paire différentielle NPN 312, commandée par la sortie symétrique ON/OFF d'une des bascules 40A ou 40B, et alimentée par une source de courant 311 recevant la tension de référence VW fournie par le régulateur 20. La source de courant 313 est identique à celle 233 du régulateur, et la source de courant 311 est identique à celle du miroir 234 du régulateur ; elles ont donc la même loi en température, le même niveau de bruit et la même variation avec la résistance/carré du procédé ; quand la source 313 est active, son courant a toutes les propriétés électriques du courant de référence unitaire du régulateur. La base du transistor PNP 313 est connectée à l'émetteur d'un transistor 314 de type NPN dont la base est polarisée par la tension VY fournie par le régulateur, et dont le collecteur est relié à l'alimentation VCC. Ces circuits doivent agir en quelques nanosecondes. La partie 31 crée un courant commuté rapidement, sortant de la source 313, qui actionne la source de courant 32. Lorsque la source 313 est au repos, la paire 312 est polarisée de telle façon que le courant venant de la source 311 passe par celui des transistors qui est connecté à l'émetteur du transistor PNP, et le collecteur de l'autre transistor n'envoie que très peu de courant à la base du transistor PNP, les valeurs des éléments étant choisies pour que le potentiel sur l'émetteur du transistor PNP soit proche de celui attendu dans l'état opposé (source 313 active). Ainsi lorsqu'il y a commutation, le transistor PNP voit simultanément un courant entrant à son émetteur et un fort appel de courant à sa base, et la mise en conduction du transistor PNP est particulièrement rapide. L'arrêt suit la démarche inverse et est rapide également.

Le courant sortant du circuit de commande, qui sert à mettre en route l'étage de sortie SCE, doit être d'une grande qualité du point de vue du bruit. Cette caractéristique est assurée par le montage 32 comprenant un transistor 321 avec une résistance 323 branchée entre son collecteur et sa base, et une résistance 324 branchée entre sa base et son émetteur. La jonction base-émetteur d'un transistor 326 est branchée en parallèle avec celle du transistor 321, et celle d'un transistor 322 est branchée en parallèle avec la jonction base-collecteur du transistor 321. Sur le collecteur du transistor 321 est présente une tension égale au V_{be} du transistor 321, plus le V_{be} du transistor 322. Ce montage est traversé par le courant de la source de courant 313 dont le comportement est appairé avec celui du régulateur. Le courant issu de la source 313 est partagé en trois parties : le courant de base du transistor 322, un courant de polarisation dans la résistance 323, et un résidu qui passe dans le transistor 321 connecté en miroir de courant. La résistance 324 fixe le courant de sortie du miroir. Le courant passant d'abord par les résistances 323, 324 polarise la jonction base-émetteur du transistor 322, et celle du transistor 321. Ainsi l'émetteur du transistor 322 se trouve porté à une tension égale au V_{be} du transistor 321, appliquée également à la résistance 324 dont la valeur sera appelée R₃₂₄. Le courant de sortie du montage est donc à peu près égal à V_{be} / R₃₂₄. Au premier ordre, grâce à la faible impédance dynamique du transistor 321, ce courant est peu dépendant du courant d'entrée venant de la source 313, ce qui a pour effet d'atténuer l'effet de certaines sources de bruit qui seraient normalement amplifiées dans un montage classique en miroir de courant. Du fait que les composants sont de petite dimension, avec de faibles capacités, le temps de mise en route est aussi rapide que celui du transistor PNP de la source de courant 313. Le transistor 326 a pour effet de tirer du courant sur l'entrée du signal CLRN, qui permet à ce signal de descendre plus vite quand le transistor 611 de la porte 60 se bloque. Le transistor 326 est conducteur quand la source 313 fournit un courant, et donc il est conducteur au moment où la porte 60 fait retomber le signal CLRN.

Un étage 325, à deux transistors montés en cascode, est commuté par les deux signaux CLR/CLRN issus de la porte 60 est ajouté en sortie de la source de courant 32. Cet étage aiguille le courant soit vers la sortie C-SCE, soit vers un réseau de charge décrit plus loin. Le courant sortant par un des collecteurs des transistors 325 est relié à la borne de sortie C-SCE du circuit de commande, qui est connectée à la base du transistor de la source de courant de sortie SCE. L'ajustement en amplitude du courant de sortie de la pompe est assuré par un transistor NPN limiteur 332. Ce transistor reçoit la consigne de courant au moyen de la tension de commande VY générée par le régulateur 20, qui est appliquée à sa base. Le collecteur est relié à l'alimentation VCC par une résistance 333, et l'émetteur est branché à la sortie C-SCE. Le susdit réseau de charge comprend un transistor NPN 334 monté en diode et connecté à l'alimentation VCC, une résistance 335 reliant l'émetteur de ce transistor au collecteur du transistor 332, qui est relié à la connexion END-A (reliée à une entrée de la porte 60 de la figure 4), et la résistance 333. A la mise en route du circuit de commande, le courant pulsé par la source 32 sert d'abord à charger la capacité de base du transistor de la source de courant de sortie SCE. Quand la tension commence à s'établir sur cette base, une partie du courant est dévié dans la résistance 331, et la tension descend jusqu'à ce que la tension d'émetteur du transistor 332 soit assez basse pour que ce dernier commence à conduire, et amène la sortie END-A à un état bas. Quand les deux circuits de commande 30A et 30B détectent la mise en route des deux sources SCE et SNK signalées par un état bas sur la sortie END-A du circuit 30A et sur la sortie correspondante END-B du circuit 30B, la porte OU 60 fournit un état haut sur sa sortie CLR et un état bas sur sa sortie CLRN, qui commande le passage du courant dans le transistor 334, tout en continuant d'assurer un état bas sur la sortie END-A, grâce aux résistances 335 et 333. Après la commutation de la paire 325, seule la résistance de rappel 333 peut contribuer au bruit en sortie.

Les sources de courant des circuits de commande 30 sont identiques à celles utilisée dans le régulateur. La sortance de la pompe dans un sens comme dans l'autre est donc égale, définie d'une part par le courant de référence unitaire du régulateur, d'autre part par le rapport "n" du nombre de transistors constituant les sources SCE et SNK, indépendamment de l'amplitude du courant pulsé venant des circuits de commande 30. Quand le transistor 332 est actif, il présente une impédance abaissée à son émetteur au noeud C-SCE, ce qui a pour effet d'atténuer les sources de bruit en amont. Le bruit propre à la tension de consigne est introduit simultanément dans les deux voies, mais avec des polarités opposées, ce qui conduit à une annulation en sortie de la pompe. La mise en conduction du transistor 332 intervient rapidement à partir d'un seuil de tension atteinte sur son émetteur, correspondant à la somme de la tension de consigne appliquée à sa base, plus une tension V_{be}. Plus la tension descend en dessous du seuil, plus le courant sortant de l'étage 325 est dérivé dans la résistance 333. Ainsi la tension sur le noeud C-SCE varie peu. La dérivation de l'excès de courant de la source 32, qui n'est pas utilisé comme courant de base des transistors 51 ou 52 de l'étage de sortie, ni pour polariser le noeud C-CSE à travers la résistance 331, génère une rampe de tension sur la sortie END-A. La résistance 333 étant de même ordre que celle 331, cette rampe est d'autant plus raide que l'excès de courant est important, et que la capacité parasite du noeud END-A est plus faible que celle du noeud C-CSE. Il en découle un signal de détection de la fin de mise en route d'une grande rapidité et d'une excellente sensibilité.

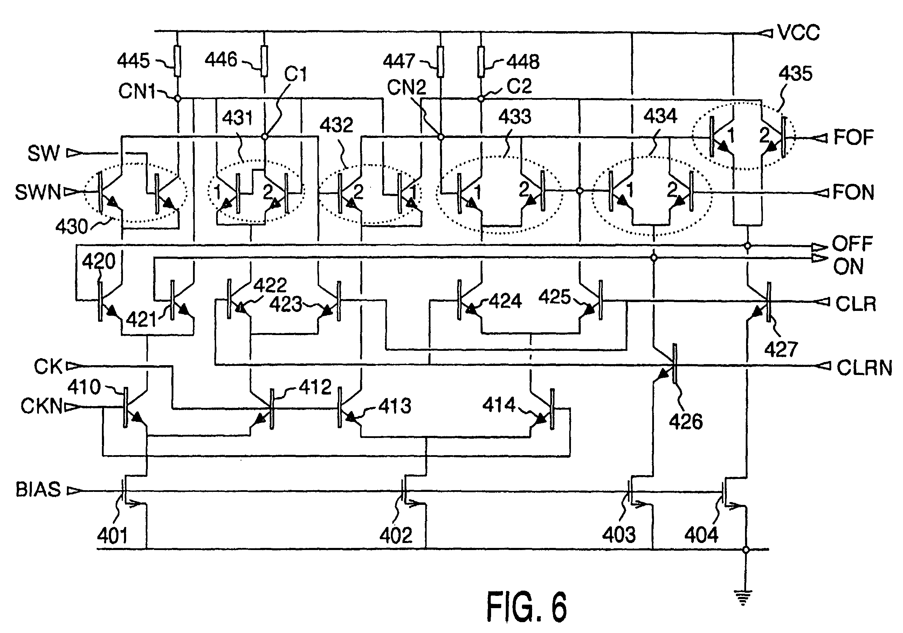

La bascule 40B, représentée par la figure 6, est réalisée à l'aide de portes CML différentielles. Elle est munie de deux transistors MOS 401 et 402, polarisés par une tension BIAS, et servant de résistances de queue pour deux paires 410/412 et 413/414, toutes deux commandées en entrée par un signal d'horloge symétrique CK/CKN, qui correspond au signal CKvar de la figure 2. Le collecteur du transistor 412 alimente en courant une paire de transistors 422/423, commutés grâce à la connexion de leurs bases au signal de définition d'état symétrique CLR/CLRN provenant de la porte 60. Le collecteur du transistor 413 alimente en courant une paire 432, celui du transistor 414 alimente en courant une paire de transistors 424/425 également commutées grâce à la connexion de leurs bases au signal symétrique CLR/CLRN. Le collecteur du transistor 422 alimente en courant une paire 431. Le collecteur d'un premier transistor de la paire 431 et la base de l'autre transistor ainsi que la base d'un premier des transistors de la paire 432, sont connectés à une connexion CN1, reliée à l'alimentation VCC par une résistance 445. Le collecteur du second transistor et la base du premier transistor de la paire 431 ainsi que la base du second transistor de la paire 432, sont connectés à une connexion C1, reliée à l'alimentation VCC par une résistance 446. Le collecteur d'un premier des transistors et la base de l'autre transistor d'une paire 433 ainsi que le collecteur du premier transistor de la paire 432, sont connectés à une connexion C2, reliée à l'alimentation VCC par une résistance 448. Le collecteur du second transistor et la base du premier transistor de la paire 433 ainsi que le collecteur du second transistor de la paire 432, sont connectés à une connexion CN2, reliée à l'alimentation VCC par une résistance 447.

Le collecteur du transistor 423 est relié à la connexion C1, celui du transistor 424 alimente en courant la paire 433, et celui du transistor 425 est relié à la connexion C2. Ainsi, la bascule comporte une première paire de transistors 431 constituant une première demi-bascule, délivrant un premier signal logique sur un premier couple de connexions logiques C1, CN1, une seconde paire de transistors 433 constituant une seconde demi-bascule, délivrant un second signal logique sur un second couple de connexions logiques C2, CN2, les deux paires étant couplées entre elles au moyen d'une paire 432 pour constituer ensemble une bascule complète, et le second couple de connexions logiques C2, CN2 constituant une sortie interne du signal logique de la bascule en mode symétrique.

La bascule comporte un système de forçage d'états destiné au test de la pompe. Les paires 434 et 435 sont prévues à cet effet. Deux transistors MOS 403, 404 sont polarisés par la tension BIAS. Lorsque la tension d'alimentation est inférieure à environ 3,5 volts, ces transistors servent de résistances de définition de courant pour des transistors 426,427 constituant des sources de courant et servant de résistances de queue pour une paire 434, et pour une paire 435. Les bases des transistors 426, 427 peuvent, comme c'est le cas ici, être reliées à la connexion CLR/CLRN, si la topographie du circuit rend cette connexion plus aisée, mais cela ne joue aucun rôle fonctionnel car la tension CLR, CLRN reste toujours telle que ces transistors restent conducteurs. Les transistors 434-1 et 435-1, fonctionnant en émetteurs suiveurs, fournissent les signaux de sortie ON et OFF, c'est-à-dire les deux composantes du signal de sortie, à partir de la sortie interne C2/CN2. Ces signaux actionnent un des circuits de commande 30A ou 30B. Les deux transistors suiveurs sont chacun l'un des transistors d'une paire dite de forçage dont la base de l'autre transistor respectivement 434-2 et 435-2 est reliée à une entrée de signal de test respectivement FON et FOF. La base du transistor 435-1 de la paire de transistors de forçage 435 étant reliée à la connexion logique CN2 constituant une demi-sortie interne, le collecteur de l'autre transistor 435-2 de la même paire 435 est relié à l'autre connexion C2. La réciproque s'applique mutatis mutandis à la paire 434.

On pourrait obtenir un forçage au moyen des connexions CLR/CLRN, mais alors les possibilités seraient réduites : on ne pourrait forcer qu'un seul état, et on ne pourrait agir que sur les deux bascules à la fois, puisque la connexion CLR/CLRN est commune aux deux bascules, alors que les paires 434, 435 permettent toutes les combinaisons.

Les signaux FON et FOF sont normalement bas, et les seconds transistors des paires 434 et 435 sont coupés et ne modifient en rien le fonctionnement. En mode test, l'un ou l'autre de ces signaux est positionné à l'état actif, la sortie respective passe à l'état "1", quelque soit le positionnement de la bascule. Du fait que le collecteur du transistor 434-2 est relié à la connexion CN2, c'est-à-dire la sortie opposée par rapport à la sortie ON commandée par 434-1, le passage du courant à travers ce transistor impose une chute de tension dans la résistance 447, de telle façon que la sortie opposée est simultanément placée à l'état zéro. La réciproque s'applique mutatis mutandis à la paire 435. Tout ceci permet, en forçant les autres éléments dans un état connu stable, de vérifier différentes caractéristiques de la pompe, dont l'amplitude des courants de sortie des sources SCE et SNK.

La bascule comporte en outre une entrée SW/SWN de commande qui est reliée aux bases d'une paire de transistors 430 dits de commande, dont les collecteurs sont reliés respectivement aux deux conducteurs C1 et CN1 du premier couple de connexions logiques. Les émetteurs de ces transistors 430 de commande sont reliés au collecteur d'un transistor 420 d'une paire de transistors 420/421, alimentée par le transistor 410, et dont les bases sont reliées aux connexions de sortie ON/OFF de la bascule. Le collecteur du transistor 421 est relié à la connexion CN1. Les portes 431, 432 exigent le pré-positionnement du signal SW/SWN : ce signal permet d'utiliser seulement un front de signal CK/CKN par période de comparaison, les autres n'étant pas acceptés. Le choix du front actif est dévolu à un compteur (extérieur au circuit de pompe) qui envoie une impulsion de sélection à l'entrée SW/SWN de la bascule. Ainsi la fréquence de comparaison est un sous-multiple de la fréquence de l'oscillateur. A partir de l'instant où la bascule est activée, l'état est maintenu pendant les cycles d'horloge suivants même si l'entrée SW est retombée, tant que l'entrée CLR/CLRN ne l'a pas remis à zéro.

Dans un autre mode de réalisation, la bascule peut ne pas comporter la paire 430 ni la paire 420/421, le collecteur du transistor 410 étant alors relié directement à la connexion CN1. Dans le circuit de la figure 2, la bascule 40B comporte ces éléments, mais pas la bascule 40A. Selon les options choisies, notamment suivant qu'on utilise ou non un compteur extérieur envoyant une impulsion de sélection, les quatre combinaisons peuvent être utilisées (les deux circuits 40A et 40B avec, les deux sans, 40A avec et 40B sans, et l'inverse).

## Revendications

1. Circuit de pompe de charge destiné à être utilisé dans une boude de réglage de fréquence d'un synthétiseur de fréquence muni d'un oscillateur local et d'un oscillateur de référence, ledit circuit de pompe de charge comprenant :
- une capacité réservoir (C),
- une source de courant de charge de sortie (SCE), ladite source de courant de charge comprenant une entrée de commande destiné à recevoir un premier signal de commande (C-SCE) pour fixer le courant de charge,
- une source de courant de décharge de sortie (SNK), ladite source de courant de décharge comprenant une entrée de commande destiné à recevoir un deuxième signal de commande (C-SNK) pour fixer le courant de décharge,
- une première bascule (40A) comprenant une entrée pour recevoir un signal (CKref) généré par ledit oscillateur de référence, et une sortie destinée à générer un signal de mise en route (28) à un premier circuit de commande (30A), ledit premier circuit de commande étant destiné à générer ledit premier signal de commande (C-SCE),
- une deuxième bascule (40B) comprenant une entrée pour recevoir un signal (CKvar) généré par ledit oscillateur local, et une sortie destinée à générer un signal de mise en route (27) à un deuxième circuit de commande (308), ledit deuxième circuit de commande étant destiné à générer ledit deuxième signal de commande (C-SNK),
circuit de pompe de charge **caractérisé en ce que** chaque circuit de commande (30A, 30B) comprend :
- une première source de courant (313) constituée d'un premier transistor connecté à une résistance de charge, ledit premier transistor étant connecté sur sa base à l'émetteur d'un deuxième transistor (314) destiné à recevoir sur sa base un premier signal de polarisation (VY),
- une paire différentielle (312) polarisée par une deuxième source de courant (311) commandée par un deuxième signal de polarisation (VW), ladite paire différentielle étant constituée de transistors de polarité opposée à la polarité dudit premier transistor, la base des transistors de ladite paire différentielle étant connectées au signal différentiel de mise en route issu de la bascule à laquelle le circuit de commande est relié, un des transistors de la paire différentielle étant relié à la base dudit premier transistor et un autre transistor de la paire différentielle étant relié à l'émetteur dudit premier transistor.

2. Circuit de pompe de charge selon la revendication 1, **caractérisé en ce que** chaque circuit de commande (30A, 30B) comprend une source de courant (32) dont le courant est introduit dans un montage miroir de courant ( 321, 323, 324) comportant un circuit du type multiplicateur de V_{be}.

3. Circuit de pompe de charge selon la revendication 2, **caractérisé en ce que** le miroir de courant comprend un transistor générateur de courant (322) qui débite dans une paire de deux transistors (325) agissant en mode cascode, dont les bases sont reliées respectivement aux deux composantes d'un signal de sortie symétrique (CLR, CLRN) généré par la sortie d'une porte logique (60) de type OU, ladite porte logique comprenant une première entrée reliée à un premier signal (END-A) généré par le premier circuit de commande (30A) indiquant la fin de mise en route du premier circuit de commande (30A), une deuxième entrée reliée à un deuxième signal (END-B) généré par le deuxième circuit de commande (30B) indiquant la fin de mise en route du deuxième circuit de commande (30B), la sortie de la porte logique (60) étant reliée à une entrée de remise dans un état inactif de chacune des deux bascules (40A, 40B) et de chacun des deux circuits de commande (30A, 30B).

4. Circuit de pompe de charge selon la revendication 3, **caractérisé en ce que** le collecteur d'un premier des transistors agissant en mode cascode est relié à une alimentation (VCC) par une résistance de charge (331), le collecteur du second de ces transistors étant relié à l'alimentation (VCC) par un montage en parallèle d'un transistor (334) monté en diode et de deux résistances (333, 335) en série, le point commun entre la résistance de charge (331) et le collecteur qui lui est relié constituant la sortie (C-SCE, C-SNK) de chacun des circuits de commande (30A, 30B), le point commun aux deux résistances (333, 335) étant connecté au collecteur d'un transistor (332) dont l'émetteur est connecté à la sortie (C-SCE, C-SNK) de chacun des circuits de commande (30A, 30B) et dont la base est polarisée par ledit premier signal de polarisation (VY), le dit point commun constituant la sortie de chaque signal de fin de mise en route (END-A, END-B).

5. Circuit de pompe de charge selon l'une quelconque des revendications 1 à 4 **caractérisé en ce que** chaque bascule (40A, 40B) comporte une première paire différentielle (434) formée d'un transistor (434-1) et d'un transistor (434-2), une deuxième paire différentielle (435) formée d'un transistor (435 -1) et d'un transistor (435-2), les transistors (434-1, 435-1) étant destinés à délivrer les deux composantes (ON, OFF) de chaque signal de commande (28, 27), les transistors (434-2, 435-2) étant destinés à recevoir les deux composantes (FON, FOF) d'un signal de test.

6. Circuit intégré comprenant un circuit de pompe de charge selon l'une quelconque des revendications 1 à 5.

7. Récepteur d'ondes hertziennes comprenant un circuit de pompe de charge selon l'une quelconque des revendications 1 à 5.

## Claims

1. A charge-pump circuit intended for use in a frequency control loop of a frequency synthesizer provided with a local oscillator and a reference oscillator, said charge-pump circuit comprising:
- an integration capacitor (C),
- an output pull-up current source (SCE), said pull-up current source having a control input intended to receive a first control signal (C-SCE) for fixing the pull-up current,
- an output pull-down current source (SNK), said pull-down current source having a control input intended to receive a second control signal (C-SNK) for fixing the pull-down current,
- a first flip-flop (40A) having an input for receiving a signal (CKref) generated by said reference oscillator, and an output intended to generate a start-signal (28) at a first control circuit (30A), said first control circuit being intended to generate said first control signal (C-SCE),
- a second flip-flop (40B) having an input for receiving a signal (CKvar) generated by said local oscillator, and an output intended to generate a start-signal (27) at a second control circuit (30B), said second control circuit being intended to generate said second control signal (C-SNK),
**characterized in that** each control circuit (30A, 30B) comprises:
- a first current source (313) constituted by a first transistor connected to a load resistor, the base of said first transistor being connected to the emitter of a second transistor (314) intended to receive a first bias signal (VY) at its base,
- a differential pair (312) biased by a second current source (311) controlled by a second bias signal (VW), said differential pair being constituted by transistors having a polarity opposite to the polarity of said first transistor, the bases of the transistors of said differential pair being connected to the differential start-signal from the flip-flop to which the control circuit is connected, one of the transistors of the differential pair being connected to the base of said first transistor, and another transistor of the differential pair being connected to the emitter of said first transistor.

2. A charge-pump circuit as claimed in claim 1, **characterized in that** each control circuit (30A, 30B) comprises a current source (32) whose current is introduced into a current mirror arrangement (321, 323, 324) comprising a circuit of the V_{be} multiplier type.

3. A charge-pump circuit as claimed in claim 2, **characterized in that** the current mirror comprises a current-generating transistor (322) which supplies a current to a pair of two transistors (325) operating in a cascode mode and having their bases connected to the two respective components of a symmetrical output signal (CLR, CLRN) generated by the output of a logic gate (60) of the OR type, said logic gate having a first input connected to a first signal (END-A) generated by the first control circuit (30A) indicating the end of starting the first control circuit (30A), a second input connected to a second signal (END-B) generated by the second control circuit (30B) indicating the end of starting the second control circuit (30B), the output of the logic gate (60) being connected to an input for resetting each of the two flip-flops (40A, 40B) and each of the two control circuits (30A, 30B) to an inactive state.

4. A charge-pump circuit as claimed in claim 3, **characterized in that** the collector of a first transistor in the cascode mode is connected to a power supply (VCC) by means of a load resistor (331), the collector of the second transistor is connected to the power supply (VCC) by means of a parallel arrangement of a transistor (334) arranged in a diode configuration and two series-arranged resistors (333, 335), the common point between the load resistor (331) and the collector connected thereto constituting the output (C-SCE, C-SNK) of each control circuit (30A, 30B), the common point between the two resistors (333, 335) being connected to the collector of a transistor (332) with its emitter connected to the output (C-SCE, C-SNK) of each control circuit (30A, 30B) and the base biased by said first bias signal (VY), said common point constituting the output (END-A, END-B) of each end-signal.

5. A charge-pump circuit as claimed in any one of claims 1 to 4, **characterized in that** each flip-flop (40A, 40B) comprises a first differential pair (434) constituted by a transistor (434-1) and a transistor (434-2), a second differential pair (435) constituted by a transistor (435-1) and a transistor (435-2), the transistors (434-1, 435-1) being intended to supply the two components (ON, OFF) of each control signal (28, 27), the transistors (434-2, 435-2) being intended to receive the two components (FON, FOF) of a test signal.

6. An integrated circuit comprising a charge-pump circuit as claimed in any one of claims 1 to 5.

7. A radiowave receiver comprising a charge-pump circuit as claimed in any one of claims 1 to 5.

## Patentansprüche

1. Ladungspumpenschaltung, die zur Verwendung in einer Frequenzregelschleife eines Frequenzsynthetisierers bestimmt ist, der mit einem lokalen Oszillator und mit einem Referenzoszillator ausgerüstet ist, wobei die Schaltung aufweist:
- eine Speicherkapazität (C),
- eine Ausgangs-Ladungsstromquelle (SCE), wobei die besagte Ladungsstromquelle einen Eingang aufweist, der für den Erhalt eines ersten Steuersignals (C-SCE) zur Bestimmung des Ladungsstroms vorgesehen ist,
- eine Ausgangs-Entladungsstromquelle (SNK), wobei die besagte Entladungsstromquelle einen Eingang aufweist, der für den Erhalt eines zweiten Steuersignals (C-SNK) zur Bestimmung des Entladungsstroms vorgesehen ist,
- eine erste Kippschaltung (40A) mit einem Eingang für den Erhalt eines Signals (CKref), welches von dem besagten Referenzoszillator erzeugt wird, und einem Ausgang für die Erzeugung eines Anlaufsignals (28) für eine erste Steuerschaltung (30A) wobei die besagte erste Steuerschaltung dafür bestimmt ist das besagte erste Steuersignal (C-SCE) zu erzeugen,
- eine zweite Kippschaltung (40B) mit einem Eingang für den Erhalt eines Signals (CKvar), welches von dem besagten lokalen Oszillator erzeugt wird, und einem Ausgang für die Erzeugung eines Anlaufsignals (27) für eine zweite Steuerschaltung (30B) wobei die besagte zweite Steuerschaltung dafür bestimmt ist das besagte zweite Steuersignal (C-SNK) zu erzeugen,
**dadurch gekennzeichnete** Ladungspumpe, dass jede Steuerschaltung (30A, 30B) enthält:
- eine erste Stromquelle (313), gebildet aus einem ersten, an einen Ladungswiderstand angeschlossenen Transistor, wobei der besagte erste Transistor an die Basis des Emitters eines zweiten Transistors (314) angeschlossen ist, der für den Erhalt an seiner Basis eines ersten Polarisationssignals (VY) bestimmt ist,
- ein Differenzialpaar (312), polarisiert von einer zweiten Stromquelle (311), gesteuert von einem zweiten Polarisationssignal (VW), wobei das besagte Differenzialpaar aus Transistoren entgegengesetzter Polarität zur Polarität des besagten ersten Transistors gebildet wird, die Basis des Transistors des besagten Differenzialpaars an das Anlauf-Differenzialsignal angeschlossen ist, welches aus der Kippschaltung kommt, mit der die Steuerschaltung verbunden ist, einer der Transistoren des Differenzialpaars mit der Basis des besagten ersten Transistors verbunden ist und ein anderer Transistor des Differenzialpaars mit dem Emitter des besagten ersten Transistors verbunden ist.

2. Ladungspumpe nach Anspruch 1, **dadurch gekennzeichnet, dass** jede Steuerschaltung (30A, 30B) eine Stromquelle (32) enthält, deren Strom in eine Stromspiegelanordnung (321, 323, 324) geführt wird, welcher eine Schaltung vom Multiplikatortyp V_{be} enthält.

3. Ladungspumpe nach Anspruch 2, **dadurch gekennzeichnet, dass** der Stromspiegel einen Stromerzeugungstransistor (322) enthält, welcher in ein Paar von zwei in Kaskodenmodus arbeitenden Transistoren (325) abgibt, deren Basen respektive mit den beiden Komponenten eines symmetrischen Ausgangssignals (CLR, CLRN) verbunden sind, welches vom Ausgang eines logischen Gates (60) vom Typ ODER erzeugt wird, wobei das besagte Gate einen ersten Eingang aufweist, der mit einem ersten Signal (END-A) verbunden ist, welches von der ersten Steuerschaltung (30A) erzeugt wird und das Anlaufende der ersten Steuerschaltung (30A) anzeigt, einen zweiten Eingang, der mit einem zweiten Signal (END-B) verbunden ist, welches von einer zweiten Steuerschaltung (30B) erzeugt wird und das Anlaufende der zweiten Steuerschaltung (30B) anzeigt und der Ausgang des logischen Gates (60) mit einem Eingang zum Versetzen in einen inaktiven Zustand jeder der beiden Kippschaltungen (40A, 40B) und jeder der beiden Steuerschaltungen (30A, 30B) verbunden ist.

4. Ladungspumpe nach Anspruch 3, **dadurch gekennzeichnet, dass** ein Kollektor eines ersten der Transistoren in Kaskodenmodus arbeitet und über einen Ladungswiderstand (331) mit einer Versorgung (VCC) verbunden ist, wobei der Kollektor des zweiten dieser Transistoren über eine Anordnung parallel zum Transistor (334), als Diode geschaltet und aus zwei Widerstanden (333, 335) in Serie, mit der Versorgung (VCC) verbunden ist, der gemeinsame Punkt zwischen dem Ladungswiderstand (331) und dem Kollektor, der an ihn heranführt, den Ausgang (C-SCE, C-SNK) jeder dieser Steuerschaltung (30A, 30B) bildet, der gemeinsame Punkt der beiden Widerstände (333, 335) an den Kollektor eines Transistors (332) angeschlossen ist, dessen Emitter mit dem Ausgang (C-SCE, C-SNK) jeder der Steuerschaltungen (30A, 30B) verbunden ist und dessen Basis von dem besagten ersten Polarisationssignal (VY) polarisiert wird und der gemeinsame Punkt den Ausgang jedes Anlaufendsignals (END-A, END-B) bildet.

5. Ladungspumpe nach einem beliebigen der Ansprüche 1 bis 4, **dadurch gekennzeichnet, dass** jede Kippschaltung (40A, 40B) ein erstes Differenzialpaar (434) enthält, gebildet aus einem Transistor (434-1) und einem Transistor (434-2), ein zweites erstes Differenzialpaar (435), gebildet aus einem Transistor (435-1) und einem Transistor (435-2), die Transistoren (434-1,435-1) dazu bestimmt sind, die beiden Komponenten (ON, OFF) jedes Steuersignals (28, 27) abzugeben, wobei die Transistoren (434-2, 435-2) dazu bestimmt sind, die beiden Komponenten (FON, FOFF) eines Testsignals zu erhalten.

6. Integrierte Schaltung mit einer Ladungspumpenschaltung nach einem beliebigen der Ansprüche 1 bis 5.

7. Funkwellenempfänger mit einer Ladungspumpenschaltung nach einem beliebigen der Ansprüche 1 bis 5.
